# DEMANDE DE BREVET EUROPEEN

(11) **EP 1 248 502 A1**
(43) Date de publication de la demande: **09.10.2002**
(21) Numéro de dépôt: 01201248.0
(22) Date de dépôt: 02.04.2001
(51) Int. Cl.: H05K 3/00, B23Q 17/22, G01B 7/31

(54) **Procédé de détermination d'incertitudes pour machine à perforer des plaquettes à circuits imprimés**

(71) Demandeur: Posalux S.A., 2500 Bienne 6 (CH)
(72) Inventeur: Klay, Herbert, 3298 Oberwil (CH)
(74) Mandataire: Ravenel, Thierry Gérard Louis

(57) **Abrégé**

Il est décrit un procédé de détermination de la position de moyens de positionnement (12, 13, 14) par rapport à une référence connue, destiné à être mis en oeuvre sur une machine-outil (1) d'usinage de plaques à circuits imprimés, du type comportant notamment une table porte-pièces (3) et au moins une broche motorisée (8) portant un outil (6). Ladite machine-outil (1) comporte en outre une unité de commande comprenant notamment des moyens électroniques programmables permettant une mise en oeuvre du procédé selon l'invention de manière automatique, par des déplacements de ladite broche motorisée (8) et la détection d'interactions électromagnétiques ou électriques entre ledit outil (6) et lesdits moyens de positionnement (12, 13, 14).

## Description

La présente invention concerne un procédé de détermination de l'incertitude sur la position de moyens de positionnement de plaques à circuits imprimés par rapport à une position de référence pour une machine-outil, notamment du type machine à perforer des plaques à circuits imprimés, ladite machine comportant des moyens de positionnement desdites plaques par rapport à une unité de travail et des moyens électroniques programmables de commande de ladite machine.

Les machines-outils pour l'usinage et notamment pour le perçage de plaques à circuits imprimés connues comprennent essentiellement un bâti, une table porte-pièces montée sur le bâti et sur laquelle sont fixées lesdites plaques à circuits imprimés à usiner et/ou à percer. Lesdites machines comportent en outre au moins une unité de travail dans laquelle se trouve, par exemple, une broche de perçage motorisée destinée à recevoir un outil de coupe, tel un foret, et des moyens électromécaniques permettant un déplacement relatif de ladite unité de travail par rapport à la table porte-pièces en liaison avec un circuit de commande.

Généralement, le porte-pièces et l'unité de travail peuvent être déplacés l'un relativement par rapport à l'autre dans deux directions perpendiculaires, tandis que l'unité de travail peut en outre être déplacée dans une troisième direction, perpendiculaire aux deux autres afin de définir, par exemple, la profondeur de perçage. En règle générale, ces machines comportent plusieurs unités de travail pour pouvoir usiner en même temps plusieurs plaques ou paquets de plaques à circuits imprimés.

De manière courante, ces paquets de plaques à circuits imprimés comprennent une plaque de fond ou de sortie, un empilement de plaques à percer et une plaque de couverture ou d'entrée. Ces dernières sont généralement maintenues ensemble par des goupilles qui servent également, d'une part de référence de positionnement des plaques à circuits imprimés les unes par rapport aux autres et, d'autre part, au positionnement desdits paquets sur la table porte-pièces.

La densité de trous percés dans de telles plaques à circuits imprimés peut atteindre des valeurs élevées, de l'ordre de quelques dizaines de trous par centimètre carré, ce qui impose à l'opérateur d'une telle machine-outil de positionner lesdites goupilles sur la table porte-pièces avec une grande précision, de façon à tenir compte des tolérances prédéfinies dans le cadre du procédé de fabrication.

Cet impératif de précision constitue un inconvénient important pour l'opérateur dans la mesure où il est obligé de veiller régulièrement à ce que la position desdites goupilles soit dans la limite des tolérances admises. En effet, un non respect de ces tolérances sur la position des goupilles peut avoir des conséquences néfastes pour un fabricant de circuits imprimés, tel que rendre inutilisables des paquets de circuits imprimés percés dans ces conditions, du fait d'un mauvais positionnement des trous.

La nécessité absolue de précision est d'autant plus pénalisante, en termes de coûts et de taux d'utilisation, pour l'opérateur d'une machine-outil de ce type fonctionnant selon le principe de l'art antérieur, que la mesure de la position exacte desdites goupilles est habituellement réalisée manuellement. La détermination de l'incertitude sur la position des goupilles, qui est déduite de ladite mesure, prend donc un certain temps pendant lequel la machine ne peut être utilisée pour usiner des paquets de circuits. En outre, ladite détermination contraint l'opérateur d'une telle machine à garder un mécanicien à sa disposition pendant que ladite machine fonctionne, afin de pouvoir effectuer des vérifications périodiques de ladite incertitude entre deux séquences d'usinage et le cas échéant des opérations de correction.

La présente invention a donc pour but principal de pallier les inconvénients de l'art antérieur susmentionné en fournissant un procédé de détermination de l'incertitude sur la position des moyens de positionnement plus rapide et moins coûteux que ceux mis en oeuvre dans l'art antérieur.

A cet effet, l'invention a pour objet un procédé de détermination d'incertitudes du type mentionné plus haut, caractérisé par le fait que la détermination de ladite incertitude est réalisée de manière automatique par mise en oeuvre desdits moyens électroniques programmables.

Ainsi, le procédé selon l'invention permet à l'opérateur d'une telle machine de soulager l'emploi du temps du mécanicien normalement chargé d'effectuer la vérification sur les machines de l'art antérieur et donc d'abaisser les coûts de production. En outre, le procédé selon l'invention permet à son opérateur de gagner du temps sur la vitesse de production, dans la mesure où il est réalisé de manière automatisé par la même machine que celle utilisée pour usiner les plaques à circuits imprimés.

Dans un mode préféré de réalisation de l'invention, dans lequel ladite unité de travail comprend une broche de perçage portant un outil, tel un foret, le procédé comporte les étapes consistant à:
a) appliquer un premier potentiel électrique au foret et un second potentiel électrique, de valeur différente de celle du premier potentiel, à au moins une zone d'étendue spatiale limitée desdits moyens de positionnement,
b) mesurer le potentiel électrique du foret de façon à détecter tout changement de sa valeur,
c) déplacer ladite broche de perçage jusqu'à une distance de ladite zone telle qu'une modification de la valeur dudit premier potentiel survient du fait de son interaction avec ledit second potentiel électrique, ladite distance ayant été prédéterminée une fois pour toutes en fonction de la nature du foret et des potentiels mis en jeu,
d) mesurer précisément la position de ladite broche de perçage, puis celle du foret, au moment de ladite modification de la valeur du premier potentiel électrique,
e) calculer précisément la position desdits moyens de positionnement, à partir de ladite position du foret mesurée à l'étape d), et donc la valeur de l'incertitude sur ladite position par rapport à ladite position de référence.

En outre, dans le cas de moyens de positionnement comportant des goupilles, les étapes décrites ci-dessus sont préférentiellement appliquées à la détermination de l'incertitude sur la position desdites goupilles.

Dans un autre mode de réalisation de la présente invention, lesdites goupilles sont portées par un gabarit de réglage, de préférence de forme rectangulaire, et susceptible d'être disposée sur la table porte-pièces, au dessus d'une fente ménagée dans la face supérieure de ladite table. Les moyens de positionnement comportent dans ce cas, en plus de la fente, des moyens mécaniques disposés dans ladite fente et prévus pour coopérer avec une partie du gabarit de réglage dans le but de fixer ce dernier sur la table porte-pièces. Le positionnement de ladite fente, et donc desdits moyens mécaniques de fixation, détermine par conséquent le positionnement des goupilles. On se rend compte qu'il est alors possible de déterminer l'incertitude sur la position des moyens de positionnement par rapport à une position de référence connue par une mesure précise de la position de ladite fente, à condition de connaître les dimensions précises du gabarit de réglage. Dans ce cas, selon un mode de réalisation préféré, on détermine ladite incertitude par la mesure des positions d'au moins trois points appartenant à au moins deux côtés adjacents de la périphérie de la fente.

Une autre variante de réalisation est prévue pour être appliquée à une machine-outil du type comportant une pluralité d'unités de travail, lesquelles portent chacune une broche de perçage asservie à une certaine zone de travail, délimitée ou non, sur la table porte-pièces, l'ensemble desdites unités de travail permettant de recouvrir intégralement la surface de ladite table.

En général, dans une telle configuration les broches de perçage participent à l'usinage d'un même paquet de plaques à circuits imprimés. Ainsi, la durée de l'usinage est raccourcie. Dans ce cas, il est possible de procéder à un étalonnage permettant de connaître les positions relatives desdites broches, en effectuant la détermination de la position d'un même point de référence sur la table porte-pièces, successivement par lesdites deux broches de perçage. Si dans ce cas les moyens de positionnement comportent au moins deux goupilles, on peut mettre en oeuvre les étapes a) à e) décrites plus haut, de façon que la détermination de la position d'une première desdites goupilles est effectuée par une première desdites broches de perçage, tandis que la détermination de la position de la seconde desdites goupilles est effectuée par ladite seconde broche de perçage. De ce fait, l'incertitude sur la position de ladite première goupille est déterminée à l'aide de ladite première broche de perçage, tandis que l'incertitude sur la position de ladite deuxième goupille est déterminée à l'aide de ladite deuxième broche de perçage, ce qui permet de gagner du temps pour la mise en oeuvre du procédé selon l'invention.

L'invention sera mieux comprise à l'aide de la description suivante d'un exemple d'exécution en référence aux dessins annexés dans lesquels:
- la figure 1 est une vue en perspective schématique représentant une partie des éléments constitutifs d'une machine-outil pour usiner des plaques à circuits imprimés;
- la figure 2 est une vue de dessus schématique d'une fente ménagée sur la table porte-pièces et faisant partie des moyens de positionnement dont on veut déterminer l'incertitude sur la position grâce au procédé selon l'invention;
- la figure 3 est une vue de dessus schématique et en transparence des moyens de positionnement représentés sur la figure 2, la fente étant recouverte ici d'un gabarit de réglage portant deux goupilles de positionnement, et
- la figure 4 est une vue en coupe transversale schématique suivant la ligne IV-IV de la figure 3, sur laquelle on a en outre représenté un paquet de plaques à circuits imprimés destinées à être usinées après la mise en oeuvre du procédé selon l'invention.

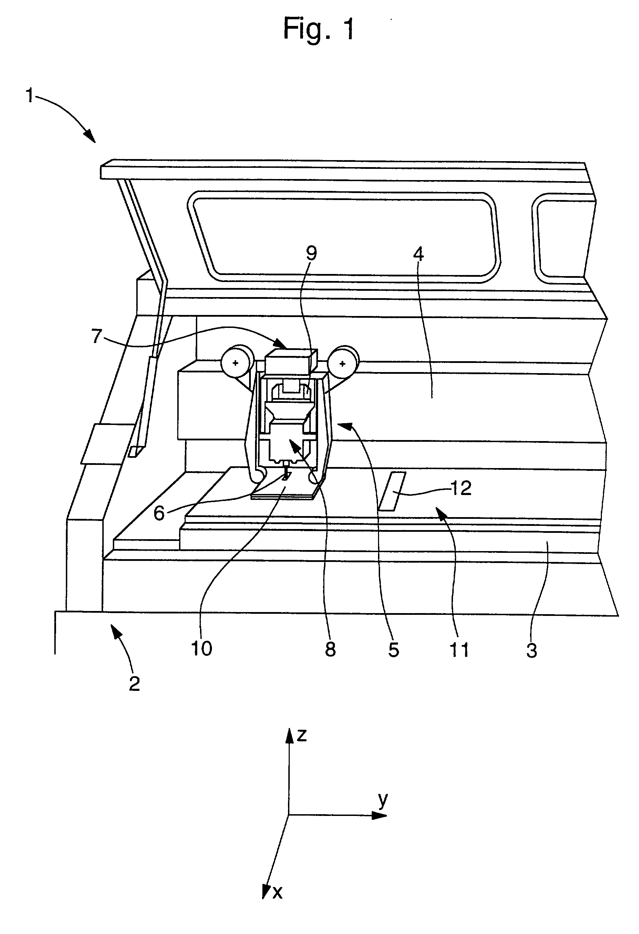

En se référant tout d'abord à la figure 1, on voit un exemple d'une machine-outil sur laquelle on peut mettre en oeuvre le procédé selon l'invention et désignée par la référence générale 1. La machine-outil 1 comprend généralement un bâti 2 sur lequel est montée une table porte-pièces 3 ainsi qu'un portique 4 fixe sur lequel sont fixées une pluralité d'unités de travail 5 destinées à entraîner un outil de coupe 6, en l'occurrence un foret. Pour des raisons de clarté, seule une unité de travail 5 a été représentée sur la figure 1, les autres étant symbolisées par des traits d'axe.

La machine comprend bien entendu des moyens classiques pour permettre un déplacement relatif des unités de travail 5 par rapport à la table porte-pièces 3. Dans l'exemple illustré, la table porte-pièces 3 est montée de façon à pouvoir se déplacer selon la direction indiquée par la flèche Y sur la figure 1, l'unité de travail 5 étant montée sur le portique 4 de façon à pouvoir se déplacer selon la direction indiquée par la flèche X sur cette même figure.

La machine-outil 1 est donc en mesure de recevoir, par l'intermédiaire de la table porte-pièces 3, une pluralité de paquets formés de plaques à circuits imprimés comprenant chacun un empilement desdites plaques à usiner et une plaque de fond goupillées ensemble, en vue d'un usinage simultané par les unités de travail 5. Chacun des paquets a sa plaque de fond qui vient s'appuyer sur la surface de la table 3 et est fixé sur cette dernière par des moyens classiques (non représentés).

Chaque unité de travail 5 est montée sur le portique 4 par l'intermédiaire d'une structure de support 7. Une broche motorisée 8 qui reçoit l'outil 6, un foret ici, est par ailleurs montée à coulissement sur un guide longitudinal 9 pour être déplacée par rapport au portique 4 selon une troisième direction perpendiculaire aux directions X et Y et indiquée par la flèche Z sur la figure 1. L'unité de travail 5 comprend en outre un presse-flan 10 classique monté sur la structure du support 7 et actionné, par exemple, au moyen de deux vérins pneumatiques (non représentés) pour appuyer les plaques à circuits imprimés sur la table porte-pièces 3.

Une telle machine-outil comporte généralement une unité de commande comprenant des moyens électroniques programmables (non représentés) et permettant d'en commander le fonctionnement, notamment les mouvements relatifs des unités de travail 5 et des broches motorisées 8. Ces moyens étant classiques, ils ne seront pas décrits plus en détails dans la présente demande.

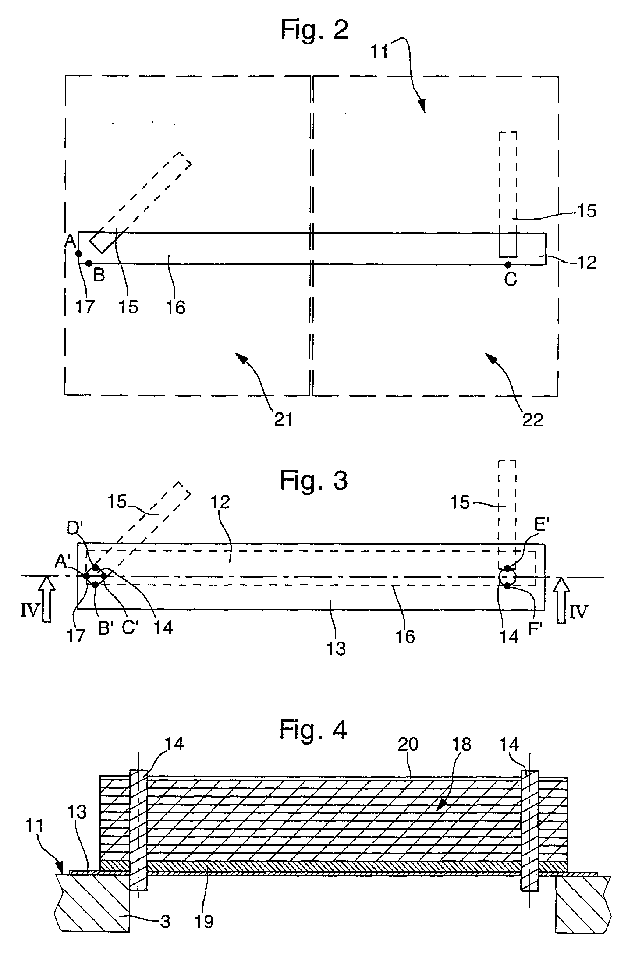

Les figures 2 et 3 représentent une même vue agrandie de la face supérieure 11 de la table porte-pièces 3 permettant de visualiser une partie des moyens de positionnement. En effet, ladite face 11 comporte une fente 12, de forme rectangulaire ici, destinée à être recouverte d'un gabarit de réglage et de positionnement 13 portant des goupilles de positionnement 14, généralement au nombre de deux. Des trous sont prévus dans les paquets de plaques à usiner pour coopérer avec des goupilles similaires, en vue du positionnement desdits paquets sur la table porte-pièces préalablement à l'étape d'usinage. Un dispositif mécanique connu est utilisé pour fixer ledit gabarit 13 sur ladite fente 12. Généralement, le gabarit de réglage 13 est de forme rectangulaire et les goupilles 14, habituellement cylindriques, y sont montées à friction de telle sorte qu'elles présentent de part et d'autre dudit gabarit 13 des parties de longueurs voisines. De cette façon, ledit dispositif mécanique prévu dans la fente 12 agit sur les parties inférieures des goupilles 14, disposées dans la fente, pour bloquer le gabarit de réglage 13 sur la table 3. De manière connue, ledit dispositif mécanique comporte notamment des "doigts" 15 venant serrer les parties inférieures desdites deux goupilles, l'une contre une bordure 16 et l'autre contre un coin 17 de la fente 12.

De ce fait, les positions respectives des goupilles 14 sont définies par la position et l'orientation de la fente 12 comme cela apparaît plus clairement sur la figure 3. On a en effet représenté, sur cette figure 3, la fente 12 de la figure 2 recouverte dudit gabarit de réglage 13 portant deux goupilles 14 et maintenue en place contre une partie de la périphérie 16, 17 de ladite fente 12 par deux "doigts" 15, appuyant sur les parties inférieures desdites goupilles 14.

La figure 4 représente l'ensemble décrit ci-dessus en coupe transversale, avec en outre un paquet 18 de plaques à circuits imprimés positionné sur la table porte-pièces 3. Sur cette figure apparaît plus clairement la structure du paquet de plaques à circuits imprimés 18, lesdites plaques étant maintenues ensemble par des goupilles 14'.

On constate en particulier que le paquet comprend une plaque de fond 19, généralement en carton, portant lesdites goupilles 14' et que ces dernières présentent une distance entre elles qui peut être, mais pas nécessairement, la même que la distance entre les goupilles 14 dudit gabarit de réglage 13, l'essentiel étant que la position et l'orientation dans le plan XY des moyens de positionnement soient connues précisément. Par conséquent, ledit gabarit de réglage 13 est utilisé pour simuler la présence des moyens de positionnement, de manière à pouvoir mettre en oeuvre le procédé selon l'invention plus commodément qu'en utilisant la plaque de fond 19 munie des goupilles 14'.

Les goupilles 14' sont disposées dans la plaque de fond 19 de façon à présenter une partie de leur longueur au-dessus de ladite plaque de fond 19, pour recevoir le paquet 18 de plaques à circuits imprimés et une partie inférieure qui interagit avec le dispositif mécanique de blocage dans la fente 12. On distingue en outre, sur la figure 4, que le paquet 18 de plaques à circuits imprimés est recouvert d'une plaque d'entrée 20 ou de couverture optionnelle, assurant notamment la protection de la première des plaques dudit paquet 18.

Le procédé selon l'invention permet de déterminer l'incertitude sur la position des moyens de positionnement des paquets de plaques à usiner sur la machine-outil. Lesdits moyens de positionnement comportent principalement, comme cela ressort de la description faite ci-dessus, la fente 12 ménagée dans la face supérieure 11 de la table porte-pièces 3 et les goupilles 14' portées par la plaque de fond 19.

D'après la description qui précède, on sait que la position du paquet 18 de plaques à usiner dépend directement de la position des goupilles 14', qui dépend elle-même de la position de la fente 12.

Pour déterminer les incertitudes sur les positions de ces différents organes de positionnement, le procédé selon l'invention fait appel à une technique connue de l'art antérieur, notamment sous la dénomination "contact drill". Cette technique, décrite dans le brevet DE 43 40 249 cité ici en référence, utilisée avec des machines-outil du même type que celles concernées par la présente invention permet notamment de mesurer précisément la profondeur du perçage effectué dans des plaques à circuits imprimés multicouches. Dans ce but, les différentes couches conductrices desdites plaques sont portées à différents potentiels électriques, de préférence nuls, tandis que le foret est porté à un potentiel électrique différent, non nul. Un dispositif de mesure, tel un voltmètre ou un comparateur est relié audit foret et permet ainsi d'en contrôler le potentiel ou ses variations à chaque instant. Lorsque, pendant l'étape de perçage, le foret entre en contact avec un des conducteurs desdites plaques à circuits imprimés, son potentiel s'en trouve modifié, cette modification étant alors détectée par ledit dispositif de mesure. Eventuellement, l'amplitude de la variation de potentiel subie par le foret peut permettre de déterminer précisément la couche de la plaque concernée avec laquelle le foret est entré en contact.

Les détails concernant la structure électronique de la machine-outil 1 et plus particulièrement du dispositif électronique de mesure ne seront pas décrits plus précisément, l'homme de l'art pourra notamment se reporter au brevet US 4,765,784 décrivant un exemple d'un tel dispositif.

Le procédé selon la présente invention apporte une amélioration aux procédés d'usinage de plaques à circuits imprimés tel que celui décrit ci-dessus en ce qu'il ne nécessite que de légères modifications techniques sur une machine-outil utilisant le principe du "contact drill" pour être mis en oeuvre.

En effet, l'outil 6, ici un foret, dont la position est précisément contrôlable reste l'instrument de mesure de la position des divers autres éléments qui nous intéressent sur la table porte-pièces 3, à savoir les moyens de positionnement. Par conséquent, conformément à la description qui précède, ledit foret 6 est porté à un premier potentiel électrique de valeur déterminée, de préférence non nulle. Les divers moyens de positionnement, quant à eux, sont portés respectivement à des potentiels électriques de valeurs différentes de celle du potentiel du foret, de préférence toutes nulles par une liaison à la terre. De cette façon un contact, voire un rapprochement, entre le foret et lesdits moyens de positionnement engendre une modification du potentiel électrique du foret pouvant être détectée par un dispositif électronique de mesure relié au foret.

Une première variante de mise en oeuvre de l'invention est illustrée sur la figure 2. Cette première variante consiste à déterminer la position précise de la fente 12 sur la table porte-pièces 3, pour en déduire l'incertitude par rapport à une position de référence.

Comme cela ressort de la figure 3, lorsque le gabarit de réglage est mis en place sur la table 3 au-dessus de la fente 12, la goupille 14 située à l'avant de la table est bloquée dans un coin 17 de ladite fente 12 par le dispositif mécanique, c'est-à-dire simultanément suivant les directions X et Y. Dans le même temps, la goupille 14 située à l'arrière de la table ne subit qu'un blocage latéral, c'est-à-dire suivant la direction X, contre le côté 16 de la fente 12 situé du même côté que ledit coin 17.

On comprend donc que déterminer l'incertitude sur la position des moyens de positionnement revient à déterminer l'incertitude sur les positions respectives dudit coin 17 et dudit côté 16 de la fente 12 par rapport à des positions de référence. Pour ce faire, la périphérie de ladite fente 12 doit être réalisée en un matériau électriquement conducteur, de façon à pouvoir être portée à un potentiel électrique de valeur bien définie différente de celle du potentiel du foret 6 et de préférence nulle.

Une position de référence étant prédéterminée, l'opérateur programme une unité de commande de façon à déplacer l'unité de travail 5, plus précisément la broche de perçage motorisée 8 portant le foret 6, jusqu'à atteindre un des côtés de la fente 12 formant ledit coin 17, à proximité dudit coin, au point noté A sur la figure 2. Dans un mode de réalisation préféré, le potentiel électrique du foret 6 subit une modification de sa valeur au moment de l'établissement d'un contact électrique entre le foret 6 et ledit côté de la fente 12. On peut cependant imaginer d'utiliser un mode d'interaction du type capacitif ou inductif plutôt que par contact électrique. Ladite modification du potentiel électrique du foret 6 est alors détectée par le dispositif électronique de mesure, qui calcule ensuite précisément la position du point A à partir de cette mesure.

On peut noter qu'il est difficile de contrôler l'arrêt de la broche motorisée 8 de façon à le provoquer instantanément du fait de l'inertie de ladite broche 8. C'est pourquoi l'unité de commande est paramétrée, de manière connue, de sorte à prendre en compte l'élasticité de l'outil 6 pour calculer la vitesse des déplacements de ladite broche 8. Ainsi, cette vitesse est choisie pour que la distance d'arrêt, après détection d'une interaction avec un des moyens de positionnement, ne soit pas supérieure à la déformation maximale que peut subir ledit outil 6 sans dépasser sa limite de déformation élastique.

Après la détermination de la position du point A, l'unité de commande envoie un signal à l'unité de travail 5 pour faire avancer le foret 6 jusqu'au deuxième côté 16 de la fente 12 à proximité du coin 17, au point noté B sur la figure 2. Le potentiel électrique du foret 6 subit alors une nouvelle modification de sa valeur au moment de l'entrée en contact du foret 6 avec le point B, ladite modification étant à nouveau détectée par le dispositif électronique de mesure, qui calcule alors précisément la position du point B. Lesdites mesures des positions des points A et B permettent de déterminer avec une grande précision la position du coin 17 de la fente 12 et d'en déduire, par comparaison avec ladite position de référence correspondante, l'incertitude sur la position dudit coin 17. Ces étapes de déductions et de comparaisons sont effectuées par les moyens électroniques de manière classique et ne seront donc pas développées davantage.

Les étapes énoncées ci-dessus sont ensuite reprises et appliquées à la détermination de la position du point C représenté sur la figure 2, puis à la détermination de l'incertitude sur sa position.

La connaissance des incertitudes sur les positions respectives des points A, B et C permet alors de déterminer l'incertitude sur la position de la fente 12 par rapport à une position de référence.

On comprend bien d'après ce qui précède que, du fait de son automatisation et de sa gestion effectuée par l'unité de commande, ce procédé de détermination de l'incertitude sur la position des moyens de positionnement est relativement rapide. Ainsi; en fonction du résultat obtenu, l'opérateur de la machine peut soit reprendre le cycle d'usinage sans avoir perdu beaucoup de temps, soit faire régler la position des moyens de positionnement, le cas échéant, pour respecter les tolérances de fabrication. La rapidité et la simplicité du procédé selon l'invention permettent à l'opérateur d'une telle machine-outil d'effectuer les vérifications de tolérances plus fréquemment qu'avec les procédés manuels de l'art antérieur. Ledit opérateur se trouve ainsi moins exposé à l'obtention de circuits imprimés défectueux, du fait de la diminution des risques de mauvais positionnement des paquets de plaques à circuits imprimés au moment de leur usinage.

Dans un autre mode de réalisation du procédé selon l'invention, ledit procédé est mis en oeuvre une fois que le gabarit de réglage 13 portant les goupilles 14 est disposé sur la table porte-pièces 3. Ce mode de réalisation est préféré parce que les goupilles 14 sont disposées exactement comme le sont les goupilles 14' lors d'un cycle d'usinage. Dans la mesure où lesdites goupilles 14' sont directement au contact des paquets 18 de plaques à circuits imprimés, la précision des mesures des positions des goupilles 14 dépend donc de moins d'incertitudes que dans le mode de réalisation décrit précédemment.

Dans le présent mode de réalisation, l'opérateur doit programmer l'unité de commande de manière à mettre en oeuvre les étapes suivantes, en partie illustrées sur la figure 3 :
a) appliquer un premier potentiel électrique au foret 6, de préférence non nul, et un second potentiel électrique, de valeur différente de celle dudit premier potentiel, et de préférence nulle, aux goupilles 14,
b) mesurer le potentiel électrique du foret 6 à l'aide du dispositif électronique de mesure de façon à détecter tout changement de sa valeur,
c) déplacer le foret 6 jusqu'à la première des deux goupilles 14, afin d'y mesurer la position d'un point A' de sa périphérie via la détection de la modification du potentiel électrique du foret 6 par le dispositif électronique de mesure, tel que décrit précédemment,
d) répéter l'étape précédente pour mesurer les positions d'au moins deux points supplémentaires B' et C', de préférence trois B', C' et D', de la périphérie de ladite première goupille 14,
e) calculer précisément la position de ladite première goupille 14 à partir des mesures précédentes des points de sa périphérie, et donc la valeur de l'incertitude sur la position de ladite première goupille 14 par rapport à une première position de référence,
f) recommencer les étapes a) à e) pour déterminer les positions d'au moins deux points E' et F' de la périphérie de ladite deuxième goupille 14 puis calculer précisément la position de ladite deuxième goupille et donc l'incertitude sur la position de ladite goupille par rapport à une seconde position de référence.

Comme précédemment, en fonction du résultat obtenu, l'opérateur de la machine peut soit reprendre le cycle d'usinage sans avoir perdu beaucoup de temps, soit faire régler la position des moyens de positionnement, le cas échéant, pour respecter les tolérances de fabrication. Une autre variante de réalisation du procédé selon l'invention est prévue plus particulièrement pour être appliquée à des machines-outil du type comportant une pluralité d'unités de travail 5. Dans cette variante, les étapes de mesures décrites dans les variantes précédentes sont légèrement modifiées en ce que les positions des différentes parties des moyens de positionnement sont respectivement déterminées par différentes unités de travail 5.

Plus précisément, dans le cas d'une machine-outil 1 comportant deux unités de travail 5 travaillant sur une même paquet, par exemple, le procédé décrit plus haut permettant de déterminer l'incertitude sur la position de la fente 12 n'est que légèrement modifié. On note, comme cela a été signalé précédemment que, lorsque deux unités de travail usinent un même paquet de plaques, on connaît précisément leurs positions relatives et le travail d'usinage est réparti entre elles, chacune ayant ainsi son propre programme d'usinage. Par conséquent, les moyens de positionnement s'étendant généralement sur une grande partie du poste de travail 21 (figure 2), la position d'une partie d'entre eux est déterminée par une première desdites deux unités de travail, tandis que la position de l'autre partie est déterminée par ladite deuxième unité de travail, notamment dans le cas où la course d'une desdites unités de travail n'est pas suffisamment étendue pour atteindre l'ensemble des moyens de positionnement.

La présente variante est donc caractérisée par rapport à la première en ce que la détermination des positions des points A et B est effectuée par une première des deux unités de travail 5, tandis que la détermination de la position du point C est effectuée par la seconde des deux unités de travail.

Le procédé s'achève ensuite comme les précédents, c'est-à-dire par le calcul de l'incertitude sur la position des moyens de positionnement, ici de la fente, par rapport à une position de référence prédéterminée.

La description qui précède correspond à des modes de réalisation préférés de l'invention et ne saurait en aucun cas être considérée comme limitative, en ce qui concerne plus particulièrement la nature de l'outil utilisé ou le nombre d'unités de travail disposées sur ladite machine-outil. En effet, il est courant sur ce type de machines d'avoir plusieurs unités de travail sur une même zone, lesdites broches des unités de travail étant dédiées à l'usinage d'un paquet de plaques à circuits intégrés. Dans ce cas, bien entendu, le procédé sera appliqué indépendamment à chaque couple d'unités de travail.

## Revendications

1. Procédé de détermination de l'incertitude sur la position de moyens de positionnement (12, 13, 14) de plaques à circuits imprimés par rapport à une position de référence pour une machine-outil (1), notamment du type machine à perforer des plaques à circuits imprimés, ladite machine (1) comportant des moyens de positionnement (12, 13, 14) desdites plaques par rapport à une unité de travail (5) et des moyens électroniques programmables de commande de ladite machine, dans lequel la détermination de ladite incertitude est réalisée de manière automatique par mise en oeuvre desdits moyens électroniques.

2. Procédé selon la revendication 1, dans lequel ladite unité de travail comprend une broche de perçage (8) portant un foret (6), le procédé comportant les étapes consistant à:
a) appliquer un premier potentiel électrique au foret (6) et un second potentiel électrique, de valeur différente de celle du premier potentiel, à au moins une zone (14, 16, 17) d'étendue spatiale limitée desdits moyens de positionnement (12, 13, 14),
b) mesurer le potentiel électrique du foret (6) de façon à détecter tout changement de sa valeur,
c) déplacer ladite broche de perçage (8) jusqu'à une distance de ladite zone (14, 16, 17) telle qu'une modification de la valeur dudit premier potentiel survient du fait de son interaction avec ledit second potentiel électrique, ladite distance ayant été prédéterminée une fois pour toutes en fonction de la nature du foret (6) et des potentiels mis en jeu,
d) mesurer précisément la position de ladite broche de perçage (8), puis celle du foret (6), au moment de ladite modification de la valeur du premier potentiel électrique,
e) calculer précisément la position desdits moyens de positionnement (12, 13, 14), à partir de ladite position du foret (6) mesurée à l'étape d), et donc la valeur de l'incertitude sur ladite position par rapport à ladite position de référence.

3. Procédé selon la revendication 2, dans lequel ladite machine (1) comporte une table porte-pièces (3), le procédé étant **caractérisé en ce que** ledit déplacement relatif de l'unité de travail a lieu principalement dans un plan parallèle à ladite table porte-pièces (3), de façon à calculer la position des moyens de positionnement (12, 13, 14) dans le plan de ladite table porte-pièces (3).

4. Procédé selon la revendication 2 ou 3, **caractérisé en ce que** ladite interaction entre lesdits potentiels électriques est du type choisi parmi le groupe comportant les interactions du type à contact, du type capacitif et du type inductif.

5. Procédé selon la revendication 3 ou 4, dans lequel lesdits moyens de positionnement comportent au moins deux goupilles (14), le procédé étant **caractérisé en ce que** l'incertitude sur la position desdites goupilles (14) est déterminée par la mise en oeuvre des étapes a) à e) définies dans la revendication 2.

6. Procédé selon la revendication 5, dans lequel lesdites goupilles (14) sont de forme cylindrique, **caractérisé en ce que** ladite étape de détermination de l'incertitude sur la position desdites goupilles (14) comporte des étapes de mesure des positions d'au moins trois points (A', B', C') de la périphérie de l'une desdites goupilles (14) et d'au moins deux points (E', F') de la périphérie de l'autre desdites goupilles (14).

7. Procédé selon l'une des revendications 3 à 6, dans lequel lesdits moyens de positionnement comprennent une fente (12) ménagée dans ladite table porte-pièces (3) et comportant au moins un coin (17), ladite zone d'étendue spatiale limitée étant définie par la périphérie de ladite fente (12), lesdits moyens de positionnement comportant en outre une plaque de fond (19) sensiblement rectangulaire portant des goupilles (14') orientées perpendiculairement par rapport à ladite plaque de fond (19) et prévues pour coopérer avec des trous ménagés dans lesdites plaques à circuits imprimés, ladite plaque de fond (19) étant susceptible d'être positionnée sur ladite table porte-pièces (3) au dessus de ladite fente (12) de manière prédéterminée et fixée par un dispositif mécanique (15) approprié, le procédé étant **caractérisé** en ce l'incertitude sur la position dudit coin (17) est déterminée par la mise en oeuvre des étapes a) à e) définies dans la revendication 2.

8. Procédé selon la revendication 7, dans lequel ladite fente (12) est rectangulaire, le procédé étant **caractérisé en ce qu'**il comporte une étape de mesure des positions de trois points (A, B, C) pris sur au moins deux côtés adjacents de ladite fente (12).

9. Procédé selon l'une des revendications 2 à 8, dans lequel ladite machine (1) comporte au moins une deuxième broche de perçage (8) portant un foret (6) et dont la position est précisément connue par rapport à la première broche de perçage, chacune desdites broches de perçage ayant son propre programme d'usinage , lesdits moyens de positionnement (12, 13, 14) présentant une étendue spatiale importante, le procédé étant **caractérisé en ce que** l'incertitude sur la position d'une première partie des moyens de positionnement est déterminée par la mise en oeuvre des étapes a) à e) définies dans la revendication 2, par la première desdites broches de perçage (8) et l'incertitude sur la position d'une seconde partie des moyens de positionnement est déterminée par la mise en oeuvre des étapes a) à e) définies dans la revendication 2, par la deuxième desdites broches de perçage (8).
